# EUROPÄISCHE PATENTSCHRIFT

(11) **EP 3 143 849 B1**
(45) Veröffentlichungstag und Bekanntmachung des Hinweises auf die Patenterteilung: **03.07.2019**
(21) Anmeldenummer: 15709451.7
(22) Anmeldetag: 05.03.2015
(51) Int. Cl.: H05K 1/14, H05K 1/05, H05K 1/02, B60R 16/03, F02N 11/08

(54) **SCHALTUNGSANORDNUNG FÜR KRAFTFAHRZEUGE UND VERWENDUNG EINER SCHALTUNGSANORDNUNG**
CIRCUIT ARRANGEMENT FOR MOTOR VEHICLES, AND USE OF A CIRCUIT ARRANGEMENT
ENSEMBLE CIRCUIT POUR VÉHICULES À MOTEUR ET UTILISATION D'UN ENSEMBLE CIRCUIT

(30) Priorität: 13.05.2014 DE 102014006841
(43) Veröffentlichungstag der Anmeldung: 22.03.2017
(73) Patentinhaber: Auto-Kabel Management GmbH, 79688 Hausen i.W. (DE); Tazarine, Wacim, 41239 Mönchengladbach. (DE); Betscher, Simon, 41515 Grevenbroich (DE); Gronwald, Frank, 50181 Bedburg (DE); Rafati, Sohejl, 41236 Mönchengladbach (DE)
(72) Erfinder: TAZARINE, Wacim, 41239 Mönchengladbach (DE); BETSCHER, Simon, 41515 Grevenbroich (DE); GRONWALD, Frank, 50181 Bedburg (DE); RAFATI, Sohejl, 41236 Mönchengladbach (DE)
(74) Vertreter: Cohausz & Florack
(86) Internationale Anmeldenummer: PCT/EP2015/054582
(87) Internationale Veröffentlichungsnummer: WO 2015/172904

(56) Entgegenhaltungen:
- EP-A2- 1 100 294
- WO-A1-2011/032966
- DE-A1-102011 014 023

## Beschreibung

Der Gegenstand betrifft eine Schaltungsanordnung für Kraftfahrzeuge sowie die Verwendung einer Schaltungsanordnung für Kraftfahrzeuge in diversen Anwendungen.

Zunehmender Kostendruck im Bereich der Kraftfahrzeugtechnik führt dazu, dass auch elektronische Komponenten für verschiedene Einsatzzwecke geeignet sein müssen. Insbesondere in der Leistungselektronik, beispielsweise im Batteriemanagement, in der Start-Stopp-Technologie sowie im Lademanagement, z.B. bei der Rekuperation, sind individualisierte Schaltungsanordnungen heutige Praxis. Diese individualisierten Schaltungsanordnungen, die Bauraum angepasst im Bereich der Batterieleitung angeordnet werden, sind jedoch aufwändig in der Entwicklung und somit teuer. Auch deren Stückzahlen lassen sich nicht skalieren, da für jede Anwendung eine hierfür geeignete Schaltungsanordnung entwickelt werden muss.

EP1100294 A2 offenbart ein Leistungselektronikmodul in Form eines Dreipols mit einer metallischen Trägerplatte und zwei metallischen Leiterplatten, wobei Halbleiterbauelemente die Trägerplatte mit einer der Leiterplatten und die Leiterplatten untereinander verbinden.

Diese Nachteile führen zu der gegenständlichen Aufgabe, eine Schaltungsanordnung für Leistungselektronik in Kraftfahrzeugen zur Verfügung zu stellen, welche derart modular ist, dass sich diese je nach Bestückung für verschiedene Zwecke einsetzen lässt.

Diese Aufgabe wird gegenständlich durch eine Schaltungsanordnung nach Anspruch 1 sowie die Verwendung einer Schaltungsanordnung nach Anspruch 15 gelöst.

Die gegenständliche Schaltungsanordnung weist zumindest ein Halbleiterbauelement auf. Beispielsweise können hier Transistoren, wie beispielsweise FETs, MOSFETs, IGBTs, Thyristoren oder dergleichen zum Einsatz kommen. Die Schaltungsanordnung wird gegenständlich mit zumindest einem Halbleiterbauelement bestückt, wobei die Bestückung vorzugsweise mittels SMD (Surface-Mounted-Devices) Technologie erfolgt.

Für eine vielseitige Anwendbarkeit ist es notwendig, die Schaltungsanordnung derart aufzubauen, dass die Bestückung und anschließende Beschaltung bei unterschiedlichsten Anwendungen auf derselben Anordnungsmimik erfolgen kann. Das heißt, dass die Geometrie als auch das Layout der Schaltungsanordnung möglichst über viele verschiedene Anwendungen gleich gestaltet ist. Gerade das Layout, insbesondere der Leiterplatten, ist so auszuführen, dass selbst bei unterschiedlichsten Anwendungen stets das gleiche Layout verwendet werden kann. Dies hat den Vorteil, dass sich die gegenständliche Schaltungsanordnung in hohen Stückzahlen produzieren lässt und die Bestückung mit Halbleiterbauelementen dem Anwendungszweck entsprechend erfolgen kann. Durch geeignete Ansteuerung der Halbleiterbauelemente können die Schaltungsanordnungen dann in unterschiedlichen Einsatzgebieten innerhalb der Kraftfahrzeugtechnik zum Einsatz kommen. Eine einheitliche Anordnungsmimik kann dadurch erreicht werden, dass zumindest eine erste metallische Trägerplatte und zwei metallische Leiterplatten vorgesehen sind.

Die Trägerplatte als auch die Leiterplatte dienen als mechanische Träger für das bzw. die Halbleiterbauelemente und sind, da sie metallisch sind, thermisch sehr gut leitend. Hierdurch wird erreicht, dass im Bereich der Leistungselektronik die Wärmeabfuhr von den Halbleiterbauelementen ausreichend gut ist. Somit lassen sich erhöhte Stromtragfähigkeiten der Schaltungsanordnung, beispielsweise für Ströme von 50 Ampere, 100 Ampere und mehr realisieren.

Insbesondere ist die Verwendung als Gleichrichter in einem Elektrofahrzeug oder einem Hybridfahrzeug bevorzugt. Vorzugsweise wird eine Verwendung in Anwendungen vorgeschlagen, die mit Strömen von mehr als 10 A, vorzugsweise mehr als 50 A oder mehr als 300 A arbeiten.

Die Trägerplatte ist elektrisch isoliert von den Leiterplatten beabstandet. Hierbei kann ein Spalt, beispielsweise ein Luftspalt zwischen Trägerplatte und den Leiterplatten gebildet sein. Dieser Spalt kann auch mit einem Isolationsmaterial gefüllt sein.

Bei der Bestückung wird die Trägerplatte mit jeweils einer der Leiterplatten über zumindest ein Halbleiterbauelement elektrisch miteinander in Verbindung gebracht. Es sind zumindest zwei Halbleiterbauelemente vorgesehen und die Trägerplatte ist mit jeweils einer der Leiterplatten über jeweils zumindest ein Halbleiterbauelement elektrisch in Verbindung gebracht. Der elektrische Strompfad von der Trägerplatte zu den Leiterplatten ist über jeweils zumindest ein Halbleiterbauelement geführt. Je nach Art des Halbleiterbauelementes und/oder Ansteuerung des Halbleiterbauelementes lassen sich zwischen den Leiterplatten und der Trägerplatte unterschiedliche Schaltungen realisieren, die für die jeweiligen Einsatzzwecke geeignet sind.

Es hat sich herausgestellt, dass die Modularität gerade in dem Fall besonders hoch ist, wenn die Halbleiterbauelemente die Trägerplatte mit den Leiterplatten derart verbinden, dass die Trägerplatten und die Leiterplatten einen elektrischen Dreipol bilden. Im Betrieb ist über eine geeignete Ansteuerung der Halbleiterbauelemente die Schaltungsanordnung derart zu betreiben, dass die Trägerplatten und die Leiterplatten jeweils ein unterschiedliches elektrisches Potential haben können. Es ist jedoch auch möglich, die Leiterplatten kurz zu schließen und somit aus dem Dreipol einen Zweipol zu machen. Dies ist aber abhängig von der jeweiligen Anwendung. Die Anordnungsmimik ermöglicht aber stets die Realisierung eines Dreipols mit Ansteuerung von Halbleitern, insbesondere von Gate/Basis Steueranschlüssen. Diese Ansteuerung ist über Leiterbahnen auf der Leiterplatte realisiert und das Layout ist über alle Anwendungen vorzugsweise identisch.

Der gegenständliche Dreipol lässt sich in verschiedenen Schaltungen zum Einsatz bringen. Beispielsweise wird vorgeschlagen, dass der elektrische Dreipol in oder für einer elektronischen Sicherheitsbatterieklemme zum Einsatz gebracht wird. Eine solche elektronische Sicherheitsbatterieklemme dient dazu, die Batterie, insbesondere den B+-Pol vom Bordnetz trennen zu können. Im Crashfall ist es notwendig, die Batterie vom Bordnetz zu trennen, insbesondere von der Starterleitung. Hierzu muss mittels geeigneter Leistungselektronik ein sehr schnelles Schalten der Batterieleitung, ggf. auch unter Strom, möglich sein. Gegenständlich kann nun die Schaltungsanordnung mit der Trägerplatte an den Batteriepol angeschlossen werden. Zumindest eine der Leiterplatten wird elektrisch mit der Batterieleitung, insbesondere der Starterleitung, verbunden. Im Crashfall kann das Halbleiterbauelement zwischen der Trägerplatte und der Leiterplatte so angesteuert werden, dass dieses die elektrische Verbindung zwischen Trägerplatte und Leiterplatte trennt.

Eine erhöhte Stromtragfähigkeit der Sicherheitsbatterieklemme lässt sich dadurch realisieren, dass die beiden Leiterplatten ausgangsseitig kurzgeschlossen werden. Somit existieren zwei Strompfade von der Trägerplatte auf jeweils eine der Leiterplatten. Über diese beiden Strompfade fließt im Betrieb der Batteriestrom. Im Crashfall können beide Strompfade getrennt voneinander oder gemeinsam abgeschaltet werden.

Auch ist es möglich, dass eine der Leiterplatten elektrisch mit einer Batterieleitung verbunden ist, welche sicherheitskritisch ist und die andere der Leiterplatten elektrisch mit dem Teil des Bordnetzes, welches nicht sicherheitsrelevant ist. Im Crashfall kann dann beispielsweise die elektrische Verbindung zwischen der Trägerplatte und der ersten dieser beiden Leiterplatten getrennt werden, sodass eine sicherheitskritische Abschaltung erfolgt ist. Der Rest des Bordnetzes kann an der Batterie angeschlossen bleiben.

Auch ist es möglich, dass die gegenständliche Schaltungsanordnung in einer Startstromeinschaltbegrenzung zum Einsatz kommt. Die Startstromeinschaltbegrenzung ist vornehmlich im Bereich der Start-Stopp-Technologie im Einsatz. Im Startfall muss verhindert werden, dass die Bordnetzspannung einbricht. Dies ist aber regelmäßig der Fall, wenn der Starter angedreht wird. In diesem Moment ist die Starterwicklung nahezu ein Kurzschluss der Batteriepole und die Batteriespannung kann einbrechen. Es muss aber verhindert werden, dass der Starterstrom so groß wird, dass die Batteriespannung unter einen Grenzwert einbricht. Daher muss im Moment des Startens der Widerstand auf der Starterleitung erhöht sein, was zu einer Strombegrenzung führt. Der gegenständliche Dreipol kann daher beispielsweise mit der Trägerplatte mit dem Batteriepol verbunden sein. Zumindest eine der Leiterplatten kann mit der Batterieleitung verbunden sein. Zwischen der Trägerplatte und der Leiterplatte ist ein elektrischer Widerstand, der ggf. auch aus einem Halbleiter gebildet ist, angeordnet. Zusätzlich zu dem Widerstand kann ein elektrischer Schalter durch ein Halbleiterbauelement gebildet sein. Im Startmoment ist der Schalter geöffnet und der Startstrom fließt über den Widerstand und wird hierüber begrenzt. Kurze Zeit nach dem Starten kann der Schalter geschlossen werden und der Startstrom fließt dann sowohl über den Schalter als auch über den Widerstand.

Eine Startstromeinschaltbegrenzung mit einer nahezu doppelt so großen Stromtragfähigkeit kann dadurch realisiert werden, dass beide Leiterplatten ausgangsseitig mit der Batterieleitung verbunden sind. Die Trägerplatte kann mit dem Batteriepol verbunden sein. Zwischen der Trägerplatte und jeweils einer der Leiterplatten ist zumindest ein Schalter aus einem Halbleiterbauelement und ein elektrischer Widerstand geschaltet. Beide Schalter sind im Startfall geöffnet und Strom fließt über die beiden Widerstände von der Trägerplatte zu den Leiterplatten. Nach dem Starten können gleichzeitig oder auch kaskadiert nacheinander die Schalter geschlossen werden und der Startstrom fließt dann von der Trägerplatte über eine oder beide Schalter und Leiterplatten zu der Batterieleitung.

Ebenfalls in der Start-Stopp-Technologie einsatzbar, lässt sich die Schaltungsanordnung als Bordnetzstabilisator verwenden. Hierbei kann beispielsweise eine Starterbatterie als auch eine Bordnetzbatterie vorgesehen sein. Zwischen den beiden Pluspolen der Batterien kann die gegenständliche Schaltungsanordnung als Q-Diode eingesetzt werden. Die Trägerplatte ist mit dem Pluspol einer Bordnetzbatterie verbunden und zumindest eine der Leiterplatten ist mit dem Pluspol der Starterbatterie verbunden. Im Startfall kann das Halbleiterbauelement, welches als Schalter zwischen der Trägerplatte und der Leiterplatte angeordnet ist, geöffnet sein und Startstrom fließt ausschließlich von der Starterbatterie zu dem Starter. Die Bordnetzbatterie wird dann nicht durch den Starter belastet und hält ihre Spannung. Unmittelbar nach dem Starten kann der Schalter geschlossen werden.

Der Schalter kann auch als Q-Diode fungieren. Dies führt dazu, dass Ausgleichströme zwischen der Bordnetzbatterie und der Starterbatterie nur in einer Richtung möglich sind.

Insbesondere ist die Schaltungsanordnung so betreibbar, dass nicht zwingend alle drei Pole des Dreipols geschaltet sein müssen. Es kann auch ein Pol umgeschaltet sein und über geeignete Bestückungen und Steuerungen können verschiedene Funktionen realisiert werden.

Dies ist beispielsweise dann der Fall, wenn ein Batterie Überladeschutz zum Einsatz kommt. Dies ist beispielsweise Lithium Ionen Batterien notwendig. Die Schaltungsanordnung kann zwischen dem Batteriepol und Ausgängen der Batteriezellen geschaltet sein. Eine Leiterplatte ist mit dem Ausgang der Batteriezellen verbunden und eine Leiterplatte mit dem Batteriepol. Die Trägerplatte ist über Halbleiterschalter einerseits und vorzugsweise antiparallel geschaltete Dioden andererseits mit jeweils einer der Leiterplatten verbunden. Je nach Schalterstellung können dann Ströme beispielsweise nur von dem Batteriepol zu den Batteriezellen oder umgekehrt nur von den Batteriezellen zu dem Batteriepol fließen. Dies ermöglicht einen Überladeschutz für die Batteriezellen als auch eine Schutzschaltung für ein tiefes Entladen der Batteriezellen. Ein Verpolschutz ist so ebenfalls realisierbar.

Im Betrieb bietet die Schaltungsanordnung somit unterschiedliche Einsatzmöglichkeiten, je nach Bestückung der Halbleiterbauelemente als auch Ansteuerung dieser. Eine Vielzahl an Anwendungen ergibt sich dann, wenn im Betrieb die Trägerplatte ein erstes Potential des Dreipoles trägt. Darüber hinaus können die Leiterplatten zwei unterschiedliche und vom ersten Potential verschiedene Potentiale des Dreipols tragen.

Um einen elektrischen Dreipol zu bilden, wird vorgeschlagen, dass die Leiterplatten elektrisch voneinander isoliert sind. Dies kann auch durch einen Luftspalt realisiert sein. Im Falle der Verwendung als Sicherheitsbatterieklemme als auch als Startstromeinschaltbegrenzung können die Leiterplatten jedoch vorzugsweise ausgangsseitig, beispielsweise über die Kontaktlaschen, elektrisch miteinander kurzgeschlossen sein. Dann tragen die Leiterplatten natürlich ein identisches Potential und unterscheiden sich im elektrischen Potential nur noch von der Trägerplatte.

Die Halbleiterbauelemente können als Schalter oder Diode zwischen Trägerplatte und zumindest einer der Leiterplatten angeordnet sein.

Vorzugsweise ist eines der Halbleiterbauelemente ein Transistor, beispielsweise ein FET, ein MOSFET, ein IGBT oder dergleichen. Insbesondere Leadless MOSFETs haben sich als vorteilhaft herausgestellt. Die Halbleiterbauelemente sind vorzugsweise Leistungshalbleiter, mit sehr hohen Stromtragfähigkeiten von 50 Ampere und mehr.

Gemäß einem Ausführungsbeispiel wird vorgeschlagen, dass zumindest eine der Leiterplatten zwei elektrisch voneinander getrennte Kontakte des Halbleiterbauelementes trägt und dass die Trägerplatte genau einen Kontakt des Halbleiterbauelementes trägt. Insbesondere für den Fall, dass das Halbleiterbauelement ein Transistor ist, hat dieses zumindest drei elektrische Kontakte, nämlich Basis (z.B. als Schaltanschluss), Emitter und Kollektor (beide z.B. als Leistungsanschlüsse) bzw. Gate (Schaltanschluss), Drain und Source (Leistungsanschlüsse). Darüber hinaus kann bei MOSFETS ein Substratanschluss vorgesehen sein, der vorzugsweise mit Drain kurzgeschlossen sein kann.

Auf der Leiterplatte können zwei elektrische Potentiale realisiert sein, nämlich eines auf dem Trägermaterial bzw. Substrat der Leiterplatte und ein weiteres, elektrisch davon isoliert, auf Leiterbahnen der Leiterplatte. Über diese zwei Potentiale lassen sich einerseits einer der Leistungsanschlüsse und andererseits der Schaltanschluss kontaktieren. Der Schaltanschluss wird vorzugsweise mit Leiterbahnen auf der Leiterplatte verbunden und die Leistungsanschlüsse können mit dem Substrat der Leiterplatte bzw. der Trägerplatte in unmittelbarem elektrischen Kontakt stehen.

Die Trägerplatte und die Leiterplatten haben vorzugsweise ein metallisches Vollmaterial als Substrat, welches deren mechanische Stabilität gewährleistet. Dieses Material kann das elektrische Potential eines Halbleiteranschlusses, vorzugsweise des Leistungsanschlusses des Halbleiterbauelementes haben und mit diesem kurzgeschlossen sein. In diesem Fall liegt auch im Betrieb auf der Trägerplatte genau ein elektrisches Potential an. Dieses elektrische Potential ist das elektrische Potential eines Leistungsanschlusses des Halbleiterbauelementes. Durch den elektrischen Kurzschluss des Substrats der Trägerplatte mit dem Leistungsanschluss des Halbleiterbauelementes ist es möglich, eine gute Wärmeabfuhr von dem Halbleiterbauelement, insbesondere dem Leistungshalbleiter zu gewährleisten. Die Trägerplatte dient nicht nur als elektrischer Anschluss, sondern gleichzeitig auch als Kühlkörper für den Leistungshalbleiter.

Wie erwähnt, kann ein Leistungsanschluss kurzgeschlossen sein mit dem Substrat (Trägermaterial) der Leiterplatte. Ein Schaltanschluss des Halbleiterbauelementes kann dann mit Leiterbahnen, die auf der Leiterplatte angeordnet sind, kurzgeschlossen sein. Auf der Leiterplatte werden somit zwei elektronische Potentiale geführt, wobei ein elektrisches Potential das des Dreipols ist und in dem Substrat der Leiterplatte geführt ist. Das elektrische Potential zur Ansteuerung des Halbleiterbauelementes ist vorzugsweise keines des Dreipols.

Auch wird vorgeschlagen, dass die mechanische Verbindung zwischen Trägerplatte und Leiterplatte über die Halbleiterbauelemente realisiert ist. Insbesondere die Lagebeziehung zwischen Trägerplatte und Leiterplatte ist durch die Halbleiterbauelemente bevorzugt definiert.

Vorzugsweise ist die Trägerplatte sandwichartig zwischen den Leiterplatten angeordnet. Das heißt, dass die Trägerplatte an zwei gegenüberliegenden Seiten von Leiterplatten eingefasst ist.

Entlang einer Oberfläche, vorzugsweise entlang der Flachseite, sind Trägerplatte und Leiterplatte zumindest im Wesentlichen parallel zueinander. Vorzugsweise liegen die Oberflächen derart parallel zueinander, dass eine SMD-Bestückung der Trägerplatte bzw. der Leiterplatten bzw. der darauf befindlichen Anschlussbereiche und Kontaktbereiche mit den Halbleiterelementen ermöglicht ist. Toleranzen von weniger als 1 mm sind dabei bevorzugt.

Vorzugsweise sind die Flachseiten, das heißt die breiten Oberflächen von Trägerplatten und Leiterplatten, im Wesentlichen parallel zueinander angeordnet.

Die Trägerplatte und/oder die Leiterplatten bzw. deren Substrat sind aus sich heraus formstabil. Vorzugsweise sind die biegesteif. Besonders vorteilhaft ist die Kühlwirkung, wenn Trägerplatte und Leiterplatte bzw. das Substrat aus Vollmaterial, insbesondere aus monolithischem Vollmaterial gebildet sind.

Die Trägerplatten und/oder die Leiterplatten können zumindest in Teilen mit einer Isolationsschicht beschichtet sein. Hier bietet sich insbesondere ein Lötstopplack an.

Nachdem die Schaltungsanordnung mit den entsprechenden Halbleiterbauelementen bestückt wurde und ggf. weitere passive Bauelemente zwischen Trägerplatte und Leiterplatte angeordnet wurden, kann die Schaltungsanordnung in einem Gehäuse angeordnet werden. Über die Leiterbahnen der Leiterplatten ist eine externe Ansteuerung der Halbleiterbauelemente ermöglicht. Hierzu können beispielsweise Steckanschlüsse vorgesehen sein, über die eine externe Steuerschaltung angeschlossen werden kann. Die Schaltungsanordnung kann in einem Gehäuse gekapselt werden, wobei in dem Gehäuse sowohl Trägerplatte als auch Leiterplatten gemeinsam gekapselt sind. Aus dem Gehäuse heraus können Kontaktlaschen von Trägerplatte und/oder Leiterplatten geführt werden. Diese Kontaktlaschen ermöglichen den Anschluss externer Potentiale an die Schaltungsanordnung.

Die Trägerplatten und die Leiterplatten bzw. deren Substrat sind vorzugsweise aus Aluminium oder Kupfer bzw. Legierungen davon gebildet. Kupfer hat den Vorteil der sehr guten Leitfähigkeit und der hohen Wärmeleitfähigkeit. Aluminium hingegen ist erheblich leichter als Kupfer, was dem Bedürfnis der Gewichtseinsparung entgegen kommt.

Vorzugsweise werden Trägerplatte und Leiterplatte zunächst aus einem gemeinsamen metallischen Substrat gebildet. Dieses kann ein Flachmaterial, beispielsweise ein Band oder Blech sein. Das einstückige Substrat kann zunächst mittels spanhebender Verfahren so bearbeitet werden, dass Trägerplatten und Leiterplatten nur noch über dünne Stege des Substrats miteinander verbunden sind. Der Rest des Substrats zwischen Trägerplatten und Leiterplatten kann entfernt sein. Anschließend kann eine Beschichtung von Trägerplatte und Leiterplatten mit einer Isolationsschicht, beispielsweise einem Lötstopplack erfolgen. Hierbei können Kontaktbereiche, Kontaktpads als auch Anschlussbereiche ausgespart sein, sodass eine Kontaktierung des Substrats durch die Isolationsschicht hindurch möglich ist. Anschließend oder auch vor dem Aufbringen der Isolationsschicht kann das vorgefertigte Substrat als Halbzeug metallisch beschichtet werden, beispielsweise vernickelt. Nach einer darauffolgenden Bestückung mit Halbleiterbauelementen können die Stege z.B. spanhebend entfernt werden und Trägerplatten und Leiterplatten werden ausschließlich über Halbleiterbauelemente mechanisch miteinander verbunden.

Zur Kontaktierung der Halbleiterbauelemente, die zwischen Trägerplatten und Leiterplatten angeordnet sind, haben die Trägerplatten und/oder die Leiterplatten jeweils an ihren stirnseitigen Enden metallische Kontaktlaschen. Die Kontaktlaschen können so angeordnet sein, dass die Kontaktlasche der Trägerplatte an einem den Kontaktlaschen der Leiterplatte abgewandten Ende der Trägerplatte angeordnet ist. Das heißt, die Kontaktlaschen der Leiterplatten können an einem stirnseitigen Ende der Schaltungsanordnung angeordnet sein und die Kontaktlasche der Trägerplatte an dem gegenüberliegenden stirnseitigen Ende.

Um eine gute Kontaktierung zu gewährleisten, wird vorgeschlagen, dass die Kontaktlaschen frei von Isolationsmaterial sind und vorzugsweise ebenfalls verzinnt sind. Die Kontaktlaschen sind aus dem selben Substrat gebildet wie die Trägerplatte bzw. die Leiterplatten. Insbesondere sind die Kontaktlaschen einstückig aus Trägerplatte bzw. den jeweiligen Leiterplatten gebildet.

Im Bereich der Leistungselektronik kommt es zu erheblichen Temperaturschwankungen der Leistungshalbleiter. Diese Temperaturen werden gegenständlich über die Trägerplatte bzw. die Leiterplatten abgeführt. Zur Symmetrierung der Temperatur auf den Trägerplatten und den Leiterplatten wird vorgeschlagen, dass diese auf einem zusätzlichen, vorzugsweise metallischen Substrat getragen werde. Zwischen den Trägerplatten und dem Substrat, insbesondere auf der den Halbleiterbauelementen abgewandten Seite ist eine Isolationsschicht vorgesehen. Die Isolationsschicht verhindert einen elektrischen Kurzschluss der Trägerplatten mit den Leiterplatten und ist bevorzugt als Wärmeleitschicht ausgeführt. Dadurch wird erreicht, dass die Temperatur zwischen den Leiterplatten und der Trägerplatte symmetriert wird und eine gleichmäßige Wärmeabfuhr ermöglicht ist.

Gegenständlich wird auch die Verwendung einer Schaltungsanordnung vorgeschlagen. Die Schaltungsanordnung lässt sich gegenständlich in vielen verschiedenen Ausgestaltungen innerhalb eines Kraftfahrzeugs einsetzen und insbesondere im Bereich der Sicherheitsbatterieklemme, als Startstromeinschaltbegrenzung, als Bordnetzstabilisator, als Q-Diode oder als Batterieüberladeschutz.

Auf die Trägerplatte wird eine Isolationsschicht, insbesondere ein Isolationslack, aufgebracht, die die Trägerplatte elektrisch isoliert. In einem Anschlussbereich ist die Trägerplatte jedoch frei von der Isolationsschicht.

Um einen an der Leiterplatte angebrachten Halbleiter, insbesondere einem Leistungs- bzw. Hochleistungshalbleiter unmittelbar mit der Trägerplatte elektrisch als auch thermisch zu kontaktieren, wird vorgeschlagen, dass die Trägerplatte in einem Anschlussbereich metallisch beschichtet ist. Die metallische Beschichtung kann vor dem Aufbringen der Isolationsschicht oder nach dem Aufbringen der Isolationsschicht geformt werden.

Die metallische Beschichtung wird unmittelbar auf die Trägerplatte aufgebracht und dient anschließend als Kontakt für den Halbleiter. Auf der metallischen Beschichtung des Anschlussbereichs ist ein Kontakt des Halbleiters elektrisch kontaktiert. Die Trägerplatte dient somit als thermisches und elektrisches Element. Dadurch, dass die metallische Beschichtung unmittelbar für den Kontakt des Halbleiters mit der Trägerplatte dient, ist ein sehr guter thermischer Kontakt zwischen dem Halbleiter und der Trägerplatte gewährleistet. Die Trägerplatte dient unmittelbar als Zuleitung für einen Kontakt des Halbleiters und kann von einem Bereich außerhalb der Isolationsschicht, z.B. an den Kontaktlaschen elektrisch kontaktiert werden.

Die Isolationsschicht ist vorzugsweise ein Lötstopplack, der beispielsweise derart aufgebracht wird, dass der Anschlussbereich frei von der Isolationsschicht ist. Anschließend kann mittels Verzinnen der Anschlussbereich metallisch beschichtet werden.

Vorzugsweise wird die Isolationsschicht vor der metallischen Beschichtung auf die Trägerplatte aufgedruckt.

Gemäß einem Ausführungsbeispiel ist die metallische Beschichtung eine Zinnschicht. Die Zinnschicht ist vorzugsweise großflächig, beispielsweise auf jeweils einer Anschlussfläche zwischen 5 cm² und 0,5 mm² auf der Trägerplatte aufgebracht.

Um den Halbleiter mechanisch zu stützen und die elektrische Kontaktierung möglichst frei von mechanischen Spannungen zu halten, wird vorgeschlagen, dass die metallische Beschichtung im Wesentlichen planparallel zur Oberfläche der Isolationsschicht ist. In diesem Fall können nichtleitende Bereiche, die den Kontakt des Halbleiters umgeben, unmittelbar auf der Isolationsschicht aufliegen. Der Halbleiter verfügt in der Regel über einen großflächigen Drain- oder Source-Kontakt. Vorzugsweise ist der Anschlussbereiche beziehungsweise die metallische Beschichtung in ihrer Fläche im Wesentlichen kongruent zu der Fläche des Kontakts des Halbleiters.

Während der Bestückung kann der Halbleiter unmittelbar auf dem Anschlussbereich aufgesetzt werden. Nichtleitende Bereiche, insbesondere in Randbereichen des Halbleiters, können auf der Isolationsschicht aufliegen und die Befestigung des Halbleiters ist somit besonders einfach. Auch ergibt sich eine große Kontaktfläche zwischen dem Kontakt des Halbleiters und der metallischen Beschichtung, sodass neben einem guten elektrischen Kontakt auch eine hervorragende Wärmeleitung von dem Kontakt des Halbleiters in die Trägerplatte ermöglicht ist.

Wie bereits erwähnt, ist der Halbleiter beziehungsweise der Kontakt des Halbleiters elektrisch mit der Trägerplatte durch die metallische Beschichtung kontaktiert. Die Trägerplatte kann an einem freien Ende eine Kontaktlasche für eine Kontaktierung mit einer elektrischen Schaltung aufweisen. Hier ist es beispielsweise möglich, dass eine Bohrung zur Aufnahme einer Anschlussfahne vorhanden ist. Auch kann ein Kabelschuh oder ein Crimpanschluss am Ende der Trägerplatte vorgesehen sein, und so kann die Leiterplatte besonders einfach elektrisch kontaktiert werden.

Insbesondere ist dabei darauf zu achten, dass eine hohe Stromtragfähigkeit ermöglicht ist. Eine Kontaktierung mit einer elektrischen Schaltung erfolgt daher vorzugsweise mit einer Leitung mit einem Leitungsquerschnitt von zumindest 2,5 mm², sodass die Kontaktierung am Ende der Trägerplatte eine solch große Kontaktfläche aufweisen muss. Auch der Leitungsquerschnitt der Trägerplatte ist zumindest entsprechend dem Leitungsquerschnitt zu wählen, vorzugsweise jedoch größer als der Leitungsquerschnitt der angeschlossenen Leitung.

Bevorzugt sind entlang einer gemeinsamen Außenkante, insbesondere einer Längskante der Trägerplatte zwei oder mehr Anschlussbereiche nebeneinander, getrennt durch die Isolationsschicht angeordnet. Insbesondere können mehr als zwei einander zugeordnete Anschlussbereiche an einer Außenkante der Trägerplatte angeordnet sein. Auch können die Anschlussbereiche an zwei distalen Längskanten der Trägerplatte angeordnet sein.

Die Leiterplatte hat ebenfalls ein metallisches Substrat. Das Substrat kann zu der metallischen Trägerplatte gleich sein. Insbesondere können gleiche Materialien, gleiche Leiterquerschnitte und/oder gleiche Formfaktoren verwendet werden. Dies macht die Massenproduktion der Leiterplatten günstig.

Das Substrat der Leiterplatte ist ebenfalls auf mindestens einer Oberfläche elektrisch isolierend beschichtet. Der dabei verwendete Isolator kann zunächst vollflächig auf der Oberfläche des Substrats aufgebracht sein. Insbesondere kann ein herkömmlich als Träger für Leiterplatten eingesetzter Isolator verwendet werden. Dies kann eine Kunststoffplatte sein. Insbesondere kann eine aus preimpregnated fibres, zu Deutsch: "vorimprägnierte Fasern" sogenannte Prepreg Schicht als Isolator verwendet werden. Anschließend wird auf den Isolator eine Leitschicht aufgebracht. Der Isolator und die Leitschicht können vollflächig mit dem Substrat (der Trägerplatte) verpresst sein. Die Leitschicht kann beispielsweise eine Kupferschicht sein.

Aus der Leitschicht können in bekannter Weise Leiterbahnen geätzt werden, wie das bei der Herstellung von herkömmlichen Leiterplatten üblich ist.

Außerdem kann auf den Isolator und die Leitschicht eine Isolationsschicht, insbesondere eine Isolationsbeschichtung aufgebracht sein. Dies kann ebenfalls ein Isolationslack, insbesondere ein Lötstoplack sein. Dieser kann vor oder nach dem Formen der Leiterbahnen erfolgen.

Mittels Fräsen oder Bohren können Isolator sowie Leitschicht, falls noch nicht weggeätzt, durchbrochen werden, um einen Kontaktbereich zu dem Substrat zu bilden. Hierbei können fensterartige Durchbrechungen des Isolators den Kontaktbereich bilden. In dem Kontaktbereich kann das Substrat zunächst freigelegt sein, um dann hierauf zumindest ein Kontaktpad zu bilden.

Um nun eine Kontaktierung eines Halbleiters zu ermöglichen, wird vorgeschlagen, dass in dem Kontaktbereich zumindest ein metallisches Kontaktpad auf dem Substrat angeordnet ist. Dabei ist das Kontaktpad umlaufend beabstandet von dem Isolator und der Leitschicht ist. Hierbei kann das Kontaktpad zumindest aus der Ebene des Isolators herausragen. Wenn auf dem Isolator noch zusätzlich eine Isolationsschicht, z.B. ein Isolationslack gebildet ist, kann das Kontaktpad im Wesentlichen in der Ebene der Isolationsschicht enden.

Um zu vermeiden, dass ein elektrischer Kontakt zwischen dem Kontaktpad und der Leitschicht entsteht, ist das Kontaktpad vollständig umlaufend beabstandet von der der Leitschicht. Somit ist anders als bei herkömmlichen µVias das Kontaktpad nicht dazu geeignet, die Leiterbahn der Leitschicht mit dem Substrat zu verbinden, um eine Kühlung von der Leiterbahn der Leitschicht zu ermöglichen. Vielmehr wird das Substrat als elektrisch leitendes Element unmittelbar mit dem Kontaktpad kontaktiert und auf dem Kontaktpad kann ein elektrischer Kontakt, insbesondere Leistungsanschlüsse eines Halbleiters aufgebracht werden. Auch ist die Kontaktfläche im Gegensatz zu den µVias als fensterartige Durchbrechung des Isolators geformt, so dass deren Herstellung einfach ist. Die Kontaktfläche ist in der Regel 2 bis 10, vorzugsweise 4 bis 7 mal so groß wie die Fläche eines einzelnen Kontaktpads.

Insbesondere, wenn der Halbleiter ein SMD-Bauelement ist, und Leistungs- und Schaltanschlüsse entlang einer gemeinsamen Kante des Halbleiters über Kontaktpins, welche auf einer Ebene liegen, kontaktiert werden sollen, ist es vorteilhaft, wenn die Kontaktpads im Wesentlichen planparallel zu der Leitschicht sind . In diesem Fall kann der Halbleiter auf das Kontaktpad und gleichzeitig die Leitschicht aufgelegt werden. Ein Verwinkeln oder Verkanten relativ zur Leitschicht beziehungsweise dem Kontaktpad ist dann erschwert. Auf der Leitschicht beziehungsweise der Leiterbahn der Leitschicht kann ein Schaltkontaktpin kontaktiert werden und das Kontaktpad kann mit dem Leistungs-Kontaktpin kontaktiert werden.

Insbesondere können mehrere nebeneinander angeordnete Kontaktpads gebildet sein, welche jeweils eine Auflagefläche entsprechend einem Kontaktpin des Halbleiters haben. An dem Halbleiter sind entlang einer gemeinsamen Kante mehrere Leistungskontaktpins und ein Schaltkontaktpin angeordnet. An einer distalen Kante ist der entsprechende Leistungskontakt vorgesehen. Die mehreren Leistungskontaktpins, die auf der Seite des Schaltkontaktpins angeordnet sind, können auf das Kontaktpad beziehungsweise die Kontaktpads die nebeneinander angeordnet sind aufgelegt werden und der Schaltkontaktpin kann auf die Leitschicht aufgelegt werden. Anschließend kann eine besonders einfache Kontaktierung durch SMD-Löten erfolgen.

Um das Kontaktpad auf dem Substrat zu erstellen, kann der Kontaktbereich mit einem Fotoresist beschichtet werden und dann im Bereich der Kontaktpads, beabstandet von dem Isolator belichtet werden. Nach dem Entfernen des belichteten Bereichs des Fotoresists liegt dort die Trägerplatte frei. Auf diesen Bereich kann dann vorzugsweise chemisch das Kontaktpad aufgebaut werden. Die nicht belichteten Bereiche des Fotoresists bzw. des Substrats werden dabei nicht mit Kupfer beaufschlagt. Das erstellte Kontaktpad ist somit beabstandet von dem Isolator als auch der Leitschicht.

Das Kontaktpad hat eine lötbare Metalloberfläche. Diese kann wie erwähnt chemisch aufgebaut werden, beispielsweise durch Aufbringen von Nickel oder Zinn. Auch kann galvanisch Nickel oder Gold aufgebracht werden. Ein chemisches Aufbringen von Zinn oder Silber im Bereich des belichteten Bereichs ist ebenfalls möglich. Das Aufbauen des Kontaktpads kann so lange durchgeführt werden, bis dessen Oberfläche planparallel entweder zur Isolationsschicht oder zur Leitschicht ist. Hierbei kann eine Abweichung der Ebenen des Kontaktpads und der Leitschicht beziehungsweise der Isolationsschicht von weniger 10 µm und weniger als planparallel verstanden werden.

Um eine elektrische Isolation des Kontaktpads von der Leitschicht und/oder der Isolationsschicht zu ermöglichen, wird ein Abstand bzw. Ringraum zwischen Kontaktpad und Leitschicht und/oder Isolator vorgeschlagen. Der Abstand zwischen Kontaktpad und Leitschicht und/oder Isolator kann dabei zwischen 10 mm, und 0,5 mm liegen.

Der Raum zwischen dem Kontaktpad und der Leitschicht und/oder der Isolator kann frei von Füllmaterial sein. Insbesondere kann ein Luftspalt vorhanden sein. Auch ist es möglich, dass die Isolationsschicht in den Raum eingebracht wird.

Wie bereits erwähnt, kann ein Leistungskontakt mit einem Kontaktpad verbunden werden. Um den dazugehörigen Schaltkontakt, der vorzugsweise entlang der gleichen Kante des Halbleiters angeordnet ist, mit der Leitschicht zu kontaktieren, kann die Leitschicht beziehungsweise die Leiterbahn der Leitschicht ein Anschlusspad aufweisen. Das Anschlusspad hat eine lötbare Oberfläche und dient zum Anschluss des Schaltkontakts.

Sowohl das Anschlusspad als auch das Kontaktpad beziehungsweise die nebeneinander liegenden Kontaktpads können entlang einer gemeinsamen Außenkante einer Leiterplatte angeordnet sein.

Zur Kontaktierung eines Halbleiters an der Leiterplatte sind sowohl Anschlusspads als auch Kontaktpads vorgesehen. Die Kontaktpad können mehrere elektrisch gleichartige Pins, i.e. mehrere oder alle Pins eines Leistungskontakts, eines Halbleiters kontaktieren, indem nebeneinander mehrere Kontaktpads vorgesehen sind. Die Kontaktpad können mit einem oder mehreren Pins eines Leistungskontakts eines Halbleiters kontaktiert sein. Daneben dazu kann das Anschlusspad mit einem Pin eines Schaltkontakts des Halbleiters elektrisch kontaktiert sein. Die Lötbereiche des Kontaktpads als auch das Anschlusspad sind kongruent zu den Abständen der Kontaktpins des Halbleiters voneinander beabstandet.

Eine hervorragende elektrische als auch thermische Verbindung zwischen Trägerplatte/Leiterplatte und Halbleiter wird durch metallische Beschichtung des Kontaktpads ermöglicht. Insofern wird vorgeschlagen, dass der Leistungskontakt elektrisch mit dem Substrat durch das Kontaktpad kontaktiert ist.

Auf der Leitschicht können Leiterbahnen vorgesehen sein, insbesondere aus der Leitschicht geätzt sein und zumindest Teile einer Steuerschaltung für den Gate-Kontakt aufnehmen. Somit können auf der Leiterplatte unmittelbar zumindest Teile einer Steuerschaltung für den Halbleiter vorgesehen sein.

Gemäß einem Ausführungsbeispiel wird vorgeschlagen, dass zumindest ein Anschlusspad und zumindest ein Kontaktpad im Bereich einer Außenkante der Leiterplatte angeordnet sind. Insbesondere entlang einer Längskante der Leiterplatte können Anschlusspad und Kontaktpad nebeneinander angeordnet sein. Das Anschlusspad kann unmittelbar neben dem Kontaktpad an einer Außenkante der Leiterplatte angeordnet sein.

Um ein Verkanten eines aufgelöteten Halbleiters zu verhindern, wird vorgeschlagen, dass das Anschlusspad und das Kontaktpad im Wesentlichen planparallel zueinander angeordnet sind. Die Lötbereiche von Anschlusspad und Kontaktpad können so gestaltet sein, dass sie im Wesentlichen in einer Ebene liegen.

Gemäß einem Ausführungsbeispiel wird vorgeschlagen, dass das Substrat eine Stärke von zumindest 1 mm, vorzugsweise von zumindest 1,5 mm, aber weniger als 50 mm hat. Auch wird vorgeschlagen, dass der Leiterquerschnitt der Trägerplatte über 2,5 mm² ist.

Die den Anschlussbereich aufweisenden Außenkanten der Leiterplatten können parallel zu den Kontaktbereich aufnehmenden Außenkanten der Trägerplatte verlaufen. Dies erleichtert die mechanische Verbindung der Leiterplatten mit der Trägerplatte über den Halbleiter.

Nachfolgend wird der Gegenstand anhand einer Ausführungsbeispiele zeigenden Zeichnung näher erläutert. In der Zeichnung zeigen:
- Fig. 1: eine Draufsicht auf eine Trägerplatte;
- Fig. 2: eine Schnittansicht der Trägerplatte nach Figur 1;
- Fig. 3: eine weitere Schnittansicht der Trägerplatte nach Figur 1;
- Fig. 4: eine Draufsicht auf eine Leiterplatte mit Kontaktpads und Anschlusspads;
- Fig. 5a: eine Detailansicht einer Leiterplatte nach Figur 4;
- Fig. 5b: eine Schnittansicht einer Leiterplatte nach Figur 5a;
- Fig. 6: eine Schnittansicht einer Leiterplatte nach Figur 5a;
- Fig. 7: eine Draufsicht auf eine zur Bestückung vorgesehene Schaltungsanordnung;
- Fig. 8: eine Draufsicht auf eine bestückte Schaltungsanordnung;
- Fig. 9: eine Draufsicht auf eine monolithische Trägerplatte mit Leiterplatten und Trägerplatte vor dem Auftrennen der Stege;
- Fig. 10a: eine Draufsicht auf eine zur Bestückung vorgesehene Schaltungsanordnung mit zusätzlicher thermischer Symmetrierung;
- Fig. 10b: eine Schnittansicht nach Fig. 10a;
- Figs. 11a-c: Ersatzschaltbilder möglicher Schaltungen des Dreipols.

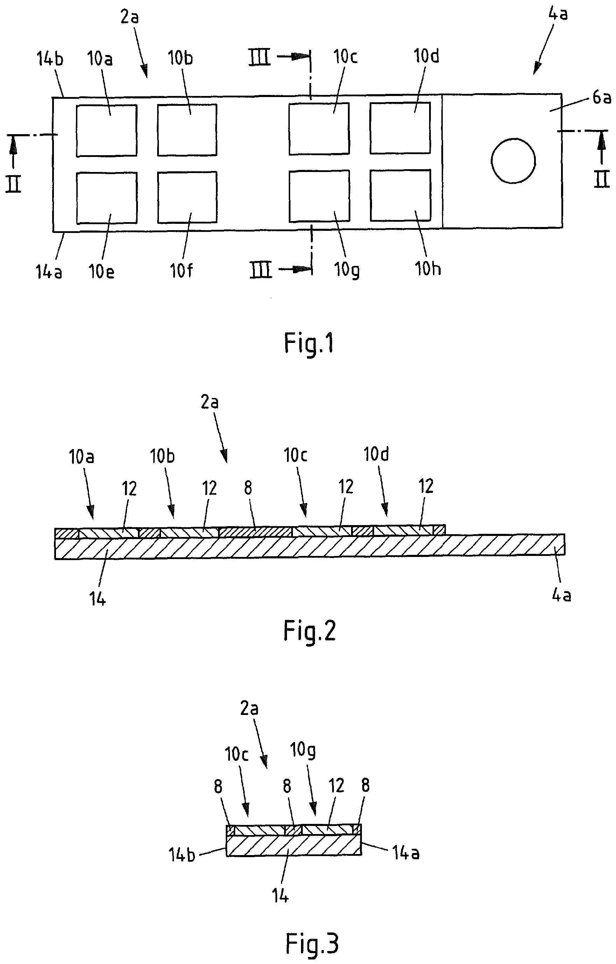

Figur 1 zeigt eine Trägerplatte 2a. Diese Trägerplatte 2a kann eine Hochstromträgerplatte mit einer Stromtragfähigkeit von über 10 Ampere, vorzugsweise von über 300 Ampere sein. Hierzu hat die Trägerplatte 2a ein metallisches Substrat. Das Substrat hat einen Leitungsquerschnitt von über 5 mm², vorzugsweise über 15 mm², insbesondere über 35 mm².

In der Draufsicht auf die Trägerplatte 2a ist zu erkennen, dass an einem ersten freien Ende 4a die Trägerplatte 2a eine Anschlusslasche 6a aufweist. Im gezeigten Fall hat die Anschlusslasche 6a eine Bohrung, die zur Aufnahme eines Kabels dienen kann. Am freien Ende 4a ist die Trägerplatte 2a z.B. mit Zinn beschichtet, insbesondere aber frei von einer Isolationsschicht.

Ein überwiegender Teil, insbesondere mehr als zwei Drittel der Fläche der Trägerplatte 2a ist isoliert und weist zumindest auf einer Flachseite eine Isolationsschicht 8 auf. Die Isolationsschicht 8 ist vorzugsweise ein Lötstopplack, der auf die Trägerplatte 2a aufgedruckt wird. Dies kann beispielsweise mittels Siebdruckverfahren erfolgen.

Wie zu erkennen ist, ist die Isolationsschicht 8 in mehreren Anschlussbereichen 10a-h nicht vorhanden. An Stelle der Isolationsschicht 8 ist in den Anschlussbereichen 10a-h eine metallische Beschichtung 12 aufgebracht. Die metallische Beschichtung 12 ist vorzugsweise eine Zinnschicht oder eine andere zum Löten geeignete Schicht.

Auch ist zu erkennen, dass die Anschlussbereiche 10a-h an gegenüberliegenden Seitenkanten 14a, 14b der Trägerplatte 2a angeordnet sind. Dies sind in der Regel die Längskanten der Trägerplatte 2a.

Während des Bedruckens der Trägerplatte 2a mit der Isolationsschicht 8 werden die Anschlussbereiche 10a-h ausgespart und anschließend wird die metallische Beschichtung 12 aufgebracht. Die metallische Beschichtung 12 kann einen Kontakt für den Halbleiter bilden. Der Aufbau der Leiterplatte 2a ist im Schnitt II-II gemäß Figur 2 näher erläutert.

In der Figur 2 ist zu erkennen, dass die Trägerplatte 2a eine metallisches Substrat 14 aufweist. Das Substrat 14 kann aus Kupfer oder Legierungen davon gebildet sein. Auch ist es möglich, dass das die Trägerplatte 2a im Kern aus Aluminium oder Legierungen davon aufweist und mit Kupfer oder Legierungen beziehungsweise Zinn beschichtet ist.

Ferner ist zu erkennen, dass auf dem Substrat 14 die Isolationsschicht 8 aufgetragen ist. In den Anschlussbereichen 10a-h ist das Substrat 14 frei von der Isolationsschicht 8 und die metallische Beschichtung 12 ist aufgebracht. Die metallische Beschichtung 12 ist unmittelbar auf dem Substrat 14 aufgebracht. In der Figur 2 ist zu erkennen, dass die metallische Beschichtung 12 im Wesentlichen entlang einer Oberfläche planparallel zu der Oberfläche der Isolationsschicht 8 verläuft.

Ferner ist zu erkennen, dass die Anschlussbereiche 10a-h beispielhaft jeweils in Gruppen aus vier Anschlussbereichen 10a, b e, f und 10c, d, g, h zueinander zugeordnet vorgesehen sind.

Die Figur 3 zeigt den Schnitt III-III gemäß der Figur 1. Zu erkennen ist erneut das Substrat 14 und die Isolationsschicht 8. Ferner ist zu erkennen, dass an der Längs- bzw. Außenkante 14a der Trägerplatte 2a der Anschlussbereich 10g und an der Längs- bzw. Außenkante 14b der Trägerplatte 2a der Anschlussbereich 10g vorgesehen ist. Es ist zu erkennen, dass die Anschlussbereiche 10a, g nicht unmittelbar mit den Längskanten 14a, b abschließt, sondern dass zwischen der Beschichtung 12 und den Längskanten 14a, b jeweils ein relativ schmaler Bereich der Isolationsschicht 8 verbleibt. Dieser Bereich ist vorzugsweise kleiner als 1 mm, vorzugsweise kleiner als 0,5 mm, insbesondere kleiner als 0,1 mm. Es ist jedoch auch möglich, dass die metallische Beschichtung 12 bis an die Längskanten 14a, b heran reicht.

Die Trägerplatte 2a eignet sich zum Anschluss an einen Drain- oder Source-Kontakt eines Transistors, insbesondere eines Hochleistungstransistors in SMD-Bauweise. Ein solcher weist auf seiner Unterseite einen großflächigen Source- oder Drain-Kontakt auf, der mit der metallischen Beschichtung 12 verlötet werden kann. Dadurch, dass die metallische Beschichtung 12 vorzugsweise im Wesentlichen kongruent zu der Fläche des Source- oder Drain Kontakts ist, kann dieser großflächig auf dem Anschlussbereich 10 aufliegen und neben einem guten elektrischen Kontakt erfolgt eine gute thermische Ableitung von thermischer Energie aus dem Halbleiter über dessen Drain- oder Source-Kontakt in das Substrat 14.

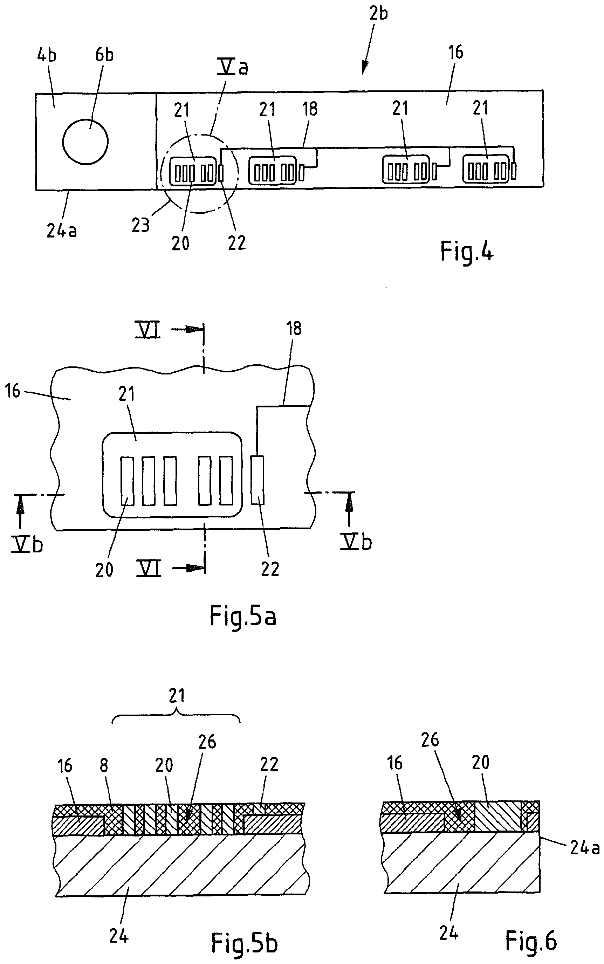

Figur 4 zeigt eine Leiterplatte 2b, die ebenfalls ein freies Ende 4b und eine Anschlusslasche 6b aufweist. Das freie Ende 4b und die Anschlusslasche 6b ist entsprechend dem freien Ende 4a und der Anschlusslasche 6a gestaltet. Ferner ist zu erkennen, dass ein Isolator 16, z.B. ein Kunststoff, ein Prepreg oder dergleichen auf die Leiterplatte 2b aufgebracht ist. Dieser Isolator 16 kann zusammen mit einer Leitschicht auf ein metallisches Substrat 24 aufgepresst werden. Anschließend kann mittels Belichtung und Ätzen aus der Leitschicht eine Leiterbahn 18 erstellt werden. Die Leiterbahn 18 verläuft entsprechend einer Schaltungstopologie auf dem Isolator 16 und dient zum Anschluss von Steuerelektronik (nicht dargestellt).

Einer Außenkante 24a zugewandt können Kontaktpads 20 und Anschlusspads 22 vorgesehen sein. Insbesondere kann das Anschlusspad 22 mit der Leiterbahn 18 unmittelbar kontaktiert sein. Die Kontaktpads 20 sind in einer fensterartigen Durchbrechung 21 des Isolators 16 angeordnet. In dieser Durchbrechung 21 ist das Substrat 24 zunächst freigelegt. Eine Isolationsschicht 8 kann später, nachdem die Kontaktpads 20 gebildet sind, aufgebracht werden. In der Durchbrechung 21 sind die Kontaktpads 20 durch einen Isolationsspalt, insbesondere einen Luftspalt, von dem Isolator 16 als auch den Leiterbahnen 18 beziehungsweise der Leitschicht beabstandet. Wie zu erkennen ist, sind in einer Durchbrechung 21 eine Mehrzahl von Kontaktpads 20 vorgesehen. Unmittelbar neben einer Durchbrechung 21, auf dem Isolator 16, kann ein dem Kontaktpads 20 zugeordnetes Anschlusspad 22 vorgesehen sein. Die Anzahl der Kontaktpads 20 als auch des Anschlusspads 22 kann entsprechend der Anzahl von Kontaktpins eines Leistungshalbleiters gewählt werden. Insbesondere hat ein Transistor zur thermischen Ableitung eine Mehrzahl von Leistungskontaktpins und genau einen Schaltkontaktpin. Der Schaltkontaktpin kann mit dem Anschlusspad 22 verbunden werden und die Leistungskontaktpins mit den Kontaktpads 20.

Um zu verhindern, dass die Kontaktpads 20 elektrisch mit dem Anschlusspad 22 kurzgeschlossen werden, muss der elektrisch leitende Bereich der Kontaktpads 20 isoliert von der Leiterbahn 18 sein. Hierzu kann, nachdem die Isolationsschicht 16 als auch die Leitschicht auf das Substrat 24 aufgepresst wurde, jeweils einem Anschlusspad 22 zugeordnete Durchbrechung 21 bis zum Substrat 24 hindurch gefräst oder gebohrt werden. In der Durchbrechung 21 kann anschließend ein Fotoresist belichtet werden. Der belichtete Bereich kann der Fläche der Kontaktpads 20 entsprechen. Dieser Bereich des Fotoresist wird entfernt und anschließend unmittelbar auf der Trägerplatte 24 die Kontaktpads aufgebaut, z.B. chemisch. Dieser Aufbau ist in Detail 23 in Figur 5a und 5b dargestellt.

Figur 5b zeigt das Detail 23 im Schnitt Vb-Vb darstellt. Figur 5b zeigt ein metallisches Substrat 24, das entsprechend dem metallischen Substrat 14 gestaltet sein kann. Auf das Substrat 24 kann der Isolator 16 und eine nicht dargestellte Leitschicht aufgepresst werden. Im Anschluss kann die Leitschicht belichtet und geätzt werden, sodass sich Leiterbahnen 18 auf dem Isolator 16 bilden.

Die Isolator 16 wird in der Durchbrechung 21 entfernt, z.B. gebohrt oder gefräst. Die Leitschicht kann in der Durchbrechung 21 ebenfalls entfernt, z.B. gebohrt oder gefräst oder insbesondere geätzt werden. Anschließend kann innerhalb der Durchbrechung 21 durch thermische und/oder galvanische Prozesse zumindest ein Kontaktpad 20 auf das Substrat 24 aufgebracht werden. Wie zu erkennen ist, ist die Durchbrechung 21 so geformt, dass das Kontaktpad 20 beabstandet von dem Isolator 16 ist. Ferner ist kein Kontakt zu der Leitschicht vorhanden und auch kein Kontakt zu den Leiterbahnen 18 vorhanden. Nachdem das Kontaktpad 20 gebildet wurde, kann auch im Bereich der Durchbrechung 21 eine Isolationsschicht 8, insbesondere wie auch auf dem Rest der Leiterplatte 2b, mit Ausnahme des Endes 4b, aufgetragen werden.

In Kontakt mit den Leiterbahnen 18 ist das Anschlusspad 22, welches durch Belichten und Ätzen einer Leitschicht hergestellt werden kann. Die Kontaktpads 20 und Anschlusspads 22 sind lötbar beschichtet und/oder aus lötfähigem Material gebildet. Wie zu erkennen ist, sind die Kontaktpads 20 an ihrer nach außen weisenden Oberfläche im Wesentlichen parallel zu der Isolationsschicht 16 und vorzugsweise planparallel zu den Leiterbahnen 18 und dem Anschlusspad 22.

Figur 5a zeigt das Detail 23 in Draufsicht. Zu erkennen ist, dass in einer Durchbrechung 21 mehrere Kontaktpads 22 in Abstand zu dem Isolator 16 vorgesehen sind. Der Isolator 16 ist in der Durchbrechung 21 entfernt und das Metall das Substrats 24 kann unmittelbar beschichtet werden. Auch ist zu erkennen, dass seitlich von der Durchbrechung 21 das Anschlusspad 22 angeordnet ist.

In der Figur 6 ist der Schnitt VI-VI der Figur 5a dargestellt. Entsprechend den metallischen Beschichtungen 12 sind auch die Kontaktpads 20 einer Außen- bzw. Längskante 24a zugewiesen, jedoch vorzugsweise von dieser beabstandet durch einen Steg des Isolators 16. Dieser Steg ist entsprechend der Figur 3 sehr schmal, vorzugsweise kleiner als 1 mm. Der Steg kann aber auch entfallen und die Kontaktpads 20 können unmittelbar an der Längskante 24a abschließen.

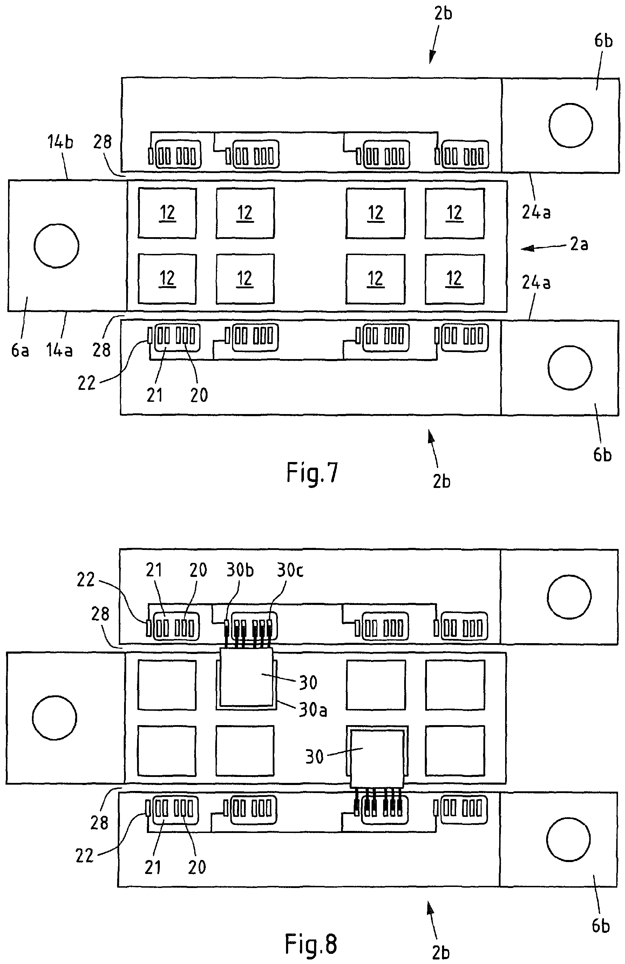

Die entsprechend Figur 1 und Figur 4 gefertigten Trägerplatte 2a und Leiterplatte 2b werden durch einen Luftspalt 28 beabstandet voneinander angeordnet. Dabei ist die Trägerplatte 2a, wie in Fig. 7 dargestellt, sandwichartig zwischen zwei Leiterplatten 2b eingefasst und beabstandet durch einen Luftspalt 28. die Längskante 14a ist der Längskante 24a einer ersten Leiterplatte 2b zugewandt und die Längskante 14b ist der Längskante 24a einer zweiten Leiterplatte 2b zugewandt. Ferner sind entlang der Längskanten 14a, 24a bzw. 14b, 24a die metallischen Beschichtungen 12 als auch die Kontaktpads 20 und Anschlusspads 22 in einem gleichen Abstand von den Kontaktlaschen 6a, 6b vorgesehen. Das führt dazu, dass wenn die Trägerplatte 2a zwischen den Leiterplatten 2b angeordnet ist, die metallischen Beschichtungen 12 den Kontaktpads 20 und Anschlusspads 22 jeweils zugewandt sind.

Die entsprechend der Figur 7 angeordneten Trägerplatte 2a und Leiterplatten 2b werden anschließend einer Bestückungsvorrichtung zugeführt und mit Transistoren 30 bestückt. Wie in Figur 8 zu erkennen ist, ist der Luftspalt 28 zwischen der Trägerplatten 2a und den Leiterplatten 2b mechanisch als auch elektrisch durch den Transistor 30 überbrückt.

Der Transistor 30 verfügt auf seiner einen Seite über einen Drain-Anschluss 30a. Dieser ist vorzugsweise großflächig auf der Unterseite des Transistors 30 angeordnet. Der Drain-Anschluss 30a wird mittels Löttechnik auf der metallischen Beschichtung 12 aufgelötet. Auf der gegenüberliegenden Seite ist der Transistor 30 mit einem Gate-Kontaktpin 30b und fünf Source-Kontaktpins 30c bestückt. Der Gate-Kontaktpin 30b ist mit dem Anschlusspad 22 mittels Löten verbunden. Die Source-Kontaktpins 30c sind mittels Löten mit den Kontaktpads 20 verbunden. Durch die Verlötung des Transistor 30 auf der metallischen Beschichtung 12 beziehungsweise den Kontaktpads 20 und Anschlusspads 22 erfolgt eine mechanische Fixierung der Trägerplatte 2a zu den Leiterplatten 2b.

Es versteht es sich, dass die Leiterbahnen 18 dazu genutzt werden können, eine Ansteuerelektronik für den Gate-Kontaktpin 30b zu kontaktieren. Es ist auch möglich, eine doppelseitige Bestückung vorzunehmen, demzufolge wären Halbleiter auf der Oberseite und der Unterseite der Leiterplatten angeordnet.

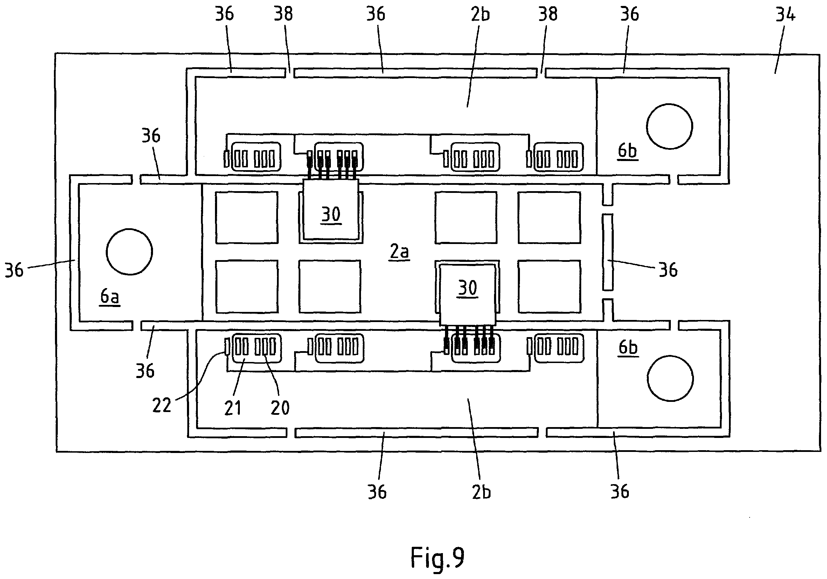

Figur 9 zeigt ein metallisches Substrat 34. In dieses sind das Substrat 14 und das Substrat 24 geformt. Dies kann z.B. durch Fräsen entsprechender Spalte 36 in dem Substrat 34 erfolgen. Zu erkennen ist, dass das Substrat 34 monolithisch ist und die Substrate 14 und 34 durch Stege 38 untereinander und mit dem Substrat 34 mechanisch verbunden sind.

Das Substrat 34 wird so bearbeitet, dass wie oben beschrieben die metallischen Beschichtungen 12 auf dem Substrat 14 und die Kontaktpads 20 und Anschlusspads 22 auf dem Substrat 24 gebildet werden. Anschließend oder davor können die Spalte 36 mit den Stegen 38 in dem Substrat 34 vorgesehen werden.

Zu erkennen ist, dass die Trägerplatte 2a zwischen den Leiterplatten 2b angeordnet ist und jeweils hiervon durch den Spalt 36 beabstandet ist. Die Kontaktlasche 6a ist an dem den Kontaktlaschen 6b abgewandten Ende der Trägerplatte 2a angeordnet. Die metallischen Beschichtungen 12 liegen gegenüber dem Anschlusspad 22 und den Kontaktpads 20 der jeweiligen Leiterplatten 2b.

Es versteht sich, dass der Begriff metallische Beschichtung 12 meint, dass auf dem Substrat 14 ein Kontakt oder Anschluss, insbesondere ein Lötanschluss gebildet ist

Eine Bestückung, wie in Fig. 9 gezeigt, kann z.B. mittels SMD Bestückung erfolgen. Zumindest ein Transistor 30 kann mit der metallischen Beschichtung 12 einerseits und mit den Kontaktpads 20 und den Anschlusspads 22 andererseits verlötet werden. Nachdem das Lot ausgehärtet ist, verbinden die Transistoren 30 die Leiterplatten 2b mit der Trägerplatte 2a mechanisch und elektrisch miteinander. Die Stege 38 können entfernt werden. Die einzige mechanische und elektrische Verbindung zwischen den Trägerplatten 14 und 24 ist dann durch die Transistoren 30 gebildet.

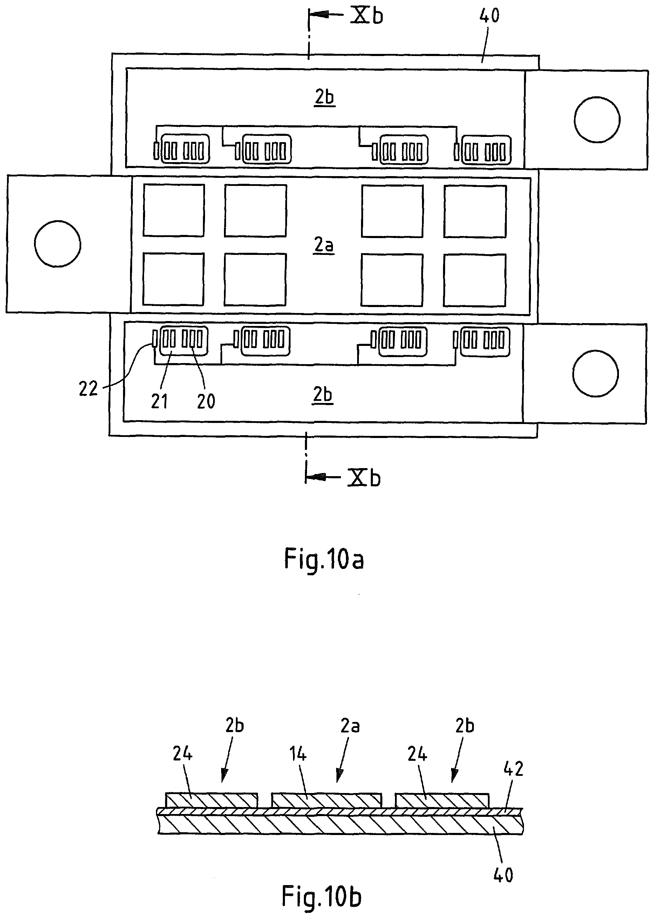

Figur 10a zeigt eine Schaltungsanordnung nach Fig. 9 ohne Bestückung. Zusätzlich zu den Substraten 14 und 24 der Trägerplatte 2a und den Leiterplatten 2b ist ein Substrat 40 vorgesehen, welches ebenfalls bevorzugt metallisch ist und eine thermische Symmetrierung bewirken soll. Hierzu ist das Substrat 40, wie in Figur 10b gezeigt, unterhalb der Leiterplatten 2b und der Trägerplatte 2a angeordnet. Zu erkennen ist, dass ein aus Wärmeleiter, z.B. Wärmepaste gebildeter Isolator 42 zwischen den Substraten 14, 24 und dem Substrat 40 gebildet ist. Von den Substraten 14, 24 wird thermische Energie an das Substrat 40 abgegeben, wenn im Betrieb die Halbleiter 30 Wärmeverluste haben und die Substrate 14, 24 sich aufheizen. Dadurch wird eine verbesserte Kühlung der Halbleiter 30 bewirkt und die Temperatur wird weitestgehend über das Substrat 40 symmetriert.

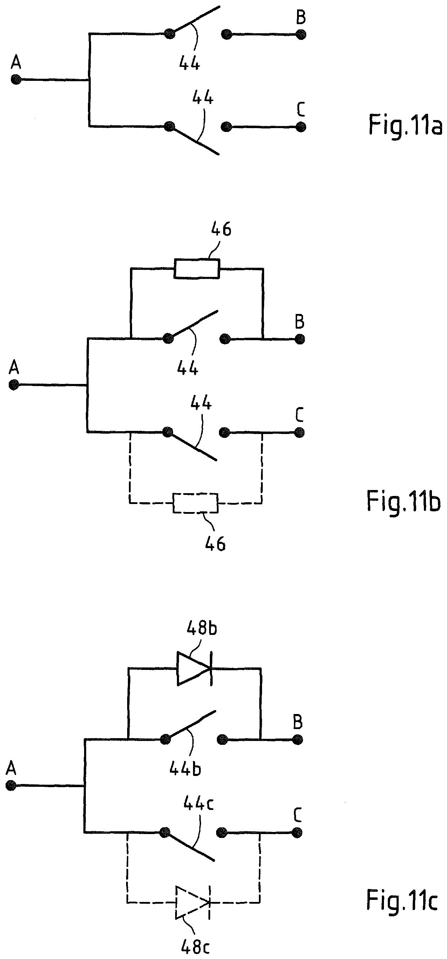

Die Figuren 11a-c zeigen mögliche Ersatzschaltbilder der gegenständlichen Schaltungsanordnung. Zu erkennen ist, dass die Schaltungsanordnung als Dreipol mit den Polen A, B und C gebildet ist. Ein Abgriff des Pols A kann an der Kontaktlasche 6a der Trägerplatte 2a erfolgen. Ein Abgriff des Pols B kann an der Kontaktlasche 6b einer ersten Leiterplatte 2b erfolgen. Ein Abgriff des Pols C kann an der Kontaktlasche 6b einer zweiten Leiterplatte 2b erfolgen.

Zwischen den Polen A und respektive B und C ist gemäß Fig. 11a ein Schalter 44 gebildet. Dieser kann jeweils durch einen Transistor 30 realisiert sein. Jeweils ein Strompfad zwischen dem Pol A und dem Pol B oder dem Pol C ist über den Schalter 44 abgesichert. Zur Anwendung in einer Sicherheitsbatterieklemme (SBK) kann der Pol A z.B. an den B+ Pol der Batterie angeklemmt sein. Zumindest einer der Pole B oder C kann mit der Starterleitung verbunden sein. Im Crashfall kann der Schalter 44 geöffnet werden, und die Starterleitung somit von der Batterie getrennt werden. Werden die Pole B und C kurzgeschlossen, kann die Stromtragfähigkeit der SBK verdoppelt werden.

Fig. 11b zeigt eine Anwendung in einem Startstromeinschaltbegrenzer (SEB). Der Pol A ist mit dem B+ Pol der Batterie verbunden. Der Pol B kann mit der Starterleitung verbunden sein. Parallel zum Schalter 44 kann ein Widerstand 46 angeordnet sein. Dieser kann auch über die Kontaktpads 20 und die Beschichtung 12 zwischen der Trägerplatte 2a und der Leiterplatte 2b angeordnet sein. Im Moment des Startens ist der Schalter 44 geöffnet und Strom kann von der Batterie zu dem Starter nur über den Widerstand fließen. Dadurch ist der Strom begrenzt. Nach dem ersten Anlaufen des Starters wird der Schalter 44 geschlossen und die Batterie ist mit dem Starter verbunden. Zur Erhöhung der Einschaltleistung kann optional ein weiterer Widerstand 46 vorgesehen sein (gestrichelt), der zwischen Pol A und Pol C angeordnet ist. Wenn beide Pole B und C mit der Starterleitung verbunden sind, ist der Startstrom über die jeweiligen Widerstände halbiert.

Fig. 11c zeigt eine Anwendung, bei der z.B. ein Schalter 44 und eine Diode 48 vorgesehen sind. Auch die Diode kann über die Beschichtung 12 und die Kontaktpads 20 zwischen der Trägerplatte 2a und der Leiterplatte 2b angeordnet sein. Ist der Pol A mit einer Starterbatterie verbunden und der Pol B mit einer Bordnetzbatterie, kann die Schaltung als Q Diode fungieren. Im Startfall kann kein Strom von der Bordnetzbatterie zum Starter fließen, solange der Schalter 44 geöffnet ist. Optional kann eine weitere Diode 48 (gestrichelt) vorgesehen sein, um die Stromtragfähigkeit der Schaltung zu verdoppeln.

Die Schaltung nach Figur 11c kann auch zum Schutz von Batteriezellen genutzt werden. Pol C kann z.B. an den Pluspol von Batteriezellen verbunden sein. Pol B kann mit dem Batterie Pluspol verbunden sein. Pol A wird nicht extern kontaktiert.

Ist der Schalter 44b geschlossen und der Schalter 44c geöffnet, kann die Batteriezelle geladen werden. Dann kann ein Ladestrom vom Pol B über die Diode 48c zu den Batteriezellen fließen. Eine Fehlpolung wird vermieden. Beim Entladen kann der Schalter 44c geschlossen und der Schalter 44b geöffnet werden. Strom kann von den Batteriezellen über due Diode 48b zum Batteriepol fließen. Eine Fehlpolung wird vermieden.

Es bieten sich weitere Anwendungen für die gegenständliche Schaltungsanordnung an, die der Übersicht halber nicht näher dargestellt werden. Je nach Bestückung und Ansteuerung lassen sich mit einer identischen Mimik unterschiedliche Schaltungen realisieren.

## Patentansprüche

1. Kraftfahrzeugsschaltungsanordnung mit
- zumindest zwei Halbleiterbauelementen (30) und
- zumindest einer ersten metallischen Trägerplatte (2a) und einer ersten metallischen Leiterplatte (2b) sowie einer zweiten metallischen Leiterplatte (2b),
- wobei die Trägerplatte elektrisch isoliert von der ersten und der zweiten Leiterplatte beabstandet ist und
- die Trägerplatte mit zumindest der ersten Leiterplatte über zumindest ein erstes Halbleiterbauelement (30) elektrisch in Verbindung gebracht ist und
- die Trägerplatte mit zumindest der zweiten Leiterplatte über zumindest ein zweites Halbleiterbauelement (30) elektrisch in Verbindung gebracht ist sodass die Trägerplatte und die Leiterplatten einen elektrischen Dreipol bilden, wobei,
- die Trägerplatte mit einem jeweiligen Leistungsanschluss des ersten und des zweiten Halbleiterbauelementes elektrisch kurzgeschlossen ist, wobei der jeweilige Leistungsanschluss mit einer unmittelbar auf der Trägerplatte aufgebrachten metallischen Beschichtung (12) elektrisch kontaktiert ist, und
- die erste und die zweite Leiterplatte Leiterbahnen (18) aufweisen und ein Leistungsanschluss des jeweils ersten Halbleiterbauelements mit der ersten Leiterplatte und des jeweils zweiten Halbleiterelements mit der zweiten Leiterplatte jeweils über ein von den Leiterbahnen beabstandetes Kontaktpad (20) kurzgeschlossen ist, wobei das Kontaktpad in einem Kontaktbereich angeordnet ist, welcher als fensterartige Durchbrechung (21) in einer Isolationsschicht (16) der Leiterplatte angeordnet ist und ein Schaltanschluss des jeweils ersten und zweiten Halbleiterbauelements mit der jeweiligen Leiterbahn kurzgeschlossen ist.

2. Kraftfahrzeugsschaltungsanordnung nach Anspruch 1,
**dadurch gekennzeichnet,**
**dass** der elektrische Dreipol zumindest als eine der Schaltungen
A) elektronische Sicherheitsbatterieklemme,
B) Startstromeinschaltbegrenzung,
C) Bordnetzspannungsstabilisator,
D) Q-Diode,
E) Batterie Überladeschutz
eingerichtet ist.

3. Kraftfahrzeugsschaltungsanordnung nach Anspruch 1 oder 2,
**dadurch gekennzeichnet,**
**dass** im Betrieb die Trägerplatte ein erstes Potential des Dreipoles trägt und dass die Leiterplatten zwei unterschiedliche und vom ersten Potential verschiedene Potentiale des Dreipoles aufweist.

4. Kraftfahrzeugsschaltungsanordnung nach einem der vorangehenden Ansprüche,
**dadurch gekennzeichnet,**
**dass** die Leiterplatten elektrisch isoliert voneinander sind und/oder dass zumindest eine der Leiterplatten zwei elektrisch voneinander getrennte Kontakte des Halbleiterbauelementes trägt und dass die Trägerplatte einen Kontakt des Halbleiterbauelements trägt.

5. Kraftfahrzeugsschaltungsanordnung nach einem der vorangehenden Ansprüche,
**dadurch gekennzeichnet,**
**dass** das Halbleiterbauelement einen Schalter oder eine Diode zwischen der Trägerplatte und zumindest einer der Leiterplatten bildet und/oder dass zumindest ein Halbleiterbauelement als Transistor gebildet ist und/oder dass das Halbleiterbauelement die Trägerplatte mechanisch mit zumindest einer der Leiterplatten verbindet.

6. Kraftfahrzeugsschaltungsanordnung nach einem der vorangehenden Ansprüche,
**dadurch gekennzeichnet,**
**dass** die Trägerplatte ein gemeinsames elektrisches Potential mit jeweils einem Anschluss des die Trägerplatte mit der Leiterplatte verbindenden Halbleiterbauelements bildet und/oder dass auf der Trägerplatte im Betrieb genau ein elektrisches Potential anliegt.

7. Kraftfahrzeugsschaltungsanordnung nach einem der vorangehenden Ansprüche,
**dadurch gekennzeichnet,**
**dass** das metallische Substrat der Leiterplatte jeweils ein elektrisches Potential mit einem Anschluss des die Leiterplatte mit der Trägerplatte verbindenden Halbleiterbauelements bildet und dass an den Leiterplatten jeweils ein elektrisches Potential zur Ansteuerung des Halbleiterbauelements geführt ist.

8. Kraftfahrzeugsschaltungsanordnung nach einem der vorangehenden Ansprüche,
**dadurch gekennzeichnet,**
**dass** die Trägerplatte sandwichartig zwischen den Leiterplatten angeordnet ist und/oder dass die Trägerplatte und die Leiterplatten zumindest entlang einer Oberfläche zumindest im Wesentlichen parallel zueinander angeordnet sind, insbesondere dass Flachseiten der Trägerplatte und der Leiterplatten im Wesentlichen parallel zueinander angeordnet sind.

9. Kraftfahrzeugsschaltungsanordnung nach einem der vorangehenden Ansprüche,
**dadurch gekennzeichnet,**
**dass** die Trägerplatte und/oder die Leiterplatten formstabil und/oder biegesteif und/oder aus einem Vollmaterial gebildet und/oder monolithisch gebildet sind.

10. Kraftfahrzeugsschaltungsanordnung nach einem der vorangehenden Ansprüche,
**dadurch gekennzeichnet,**
**dass** die Trägerplatte und/oder die Leiterplatten mit einer Isolationsschicht beschichtet sind.

11. Kraftfahrzeugsschaltungsanordnung nach einem der vorangehenden Ansprüche,
**dadurch gekennzeichnet,**
die Trägerplatte und die Leiterplatten in einem gemeinsamen Gehäuse gekapselt sind und mit jeweils einer metallischen Kontaktlasche (6a, 6b) aus dem Gehäuse heraus geführt sind und/oder dass die Trägerplatte und die Leiterplatten an jeweils einem stirnseitigen Ende eine metallische Kontaktlasche aufweisen und/oder dass die Kontaktlasche der Trägerplatte an einer den metallischen Kontaktlaschen der Leiterplatten abgewandten Ende angeordnet ist.

12. Kraftfahrzeugsschaltungsanordnung nach einem der vorangehenden Ansprüche,
**dadurch gekennzeichnet,**
**dass** die Trägerplatte und die Leiterplatten aus Aluminium oder Kupfer oder Legierungen davon gebildet sind und/oder dass die Trägerplatte und die Leiterplatte aus einem gemeinsamen metallischen Substrat gebildet sind und/oder dass die Trägerplatte und die Leiterplatten aus einem Flachmaterial, insbesondere einem Band oder Blech geformt sind und/oder dass die Trägerplatte und die Leiterplatten zumindest in Teilen, insbesondere im Bereich von Kontaktlaschen verzinnt sind und/oder dass die Kontaktlaschen einstückig mit der Trägerplatte und der jeweiligen Leiterplatte gebildet ist.

13. Kraftfahrzeugsschaltungsanordnung nach einem der vorangehenden Ansprüche,
**dadurch gekennzeichnet,**
**dass** die Trägerplatte und die Leiterplatten auf einem gemeinsamen, metallischen Substrat (40) angeordnet sind, wobei zwischen dem Substrat und der Trägerplatte und den Leiterplatten eine elektrische Trennschicht angeordnet ist.

14. Kraftfahrzeugsschaltungsanordnung nach einem der vorangehenden Ansprüche,
**dadurch gekennzeichnet,**
**dass** die Trennschicht eine Wärmeleitschicht ist.

15. Verwendung einer Kraftfahrzeugsschaltungsanordnung nach einem der vorangehenden Ansprüche, insbesondere für eine elektronische Sicherheitsbatterieklemme, eine Startstromeinschaltbegrenzung, einen Bordnetzspannungsstabilisator, eine Q-Diode, und/oder einen Batterie Überladeschutz.

## Claims

1. Motor vehicle circuit arrangement with
- at least two semiconductor components (30), and
- at least a first metallic carrier board (2a) and a first metallic printed circuit board (2b) as well as a second metallic printed circuit board (2b), wherein
- the carrier board being electrically insulated from the first and second circuit boards, and
- the carrier board being electrically connected to at least the first printed circuit board via at least one first semiconductor component (30), and
- the carrier board being electrically connected to at least the second printed circuit board via at least one second semiconductor component (30) so that the carrier board and the printed circuit boards form an electrical three-pole, wherein,
- the carrier board is electrically short-circuited to a respective power terminal of the first and second semiconductor components, the respective power terminal being electrically contacted to a metallic coating (12) applied directly to the carrier board,
- the first and second printed circuit boards have strip lines (18) and a power terminal of the respective first semiconductor component is short-circuited to the first printed circuit board and of the respective second semiconductor component to the second printed circuit board via a contact pad (20) spaced apart from the strip lines, wherein the contact pad being arranged in a contact region which is arranged as a window-like opening (21) in an insulating layer (16) of the printed circuit board and a switching terminal of the respective first and second semiconductor component being short-circuited to the respective strip line.

2. Motor vehicle circuit arrangement as described in claim 1,
**characterized in that**
the electrical three-pole is arranged as at least one of the circuitry
A) Electronic safety battery clamp,
B) Start current switch-on limitation,
C) Onboard voltage stabilizer,
D) Q diode,
E) Battery overcharge protection.

3. Motor vehicle circuit arrangement according to claim 1 or 2,
**characterized in that**
in operation, the carrier board carries a first potential of the three-pole and the printed circuit boards have two different potentials of the three-pole and different from the first potential.

4. Motor vehicle circuit arrangement according to one of the preceding claims,
**characterized in that**
the printed circuit boards are electrically insulated from one another and/or **in that** at least one of the printed circuit boards carries two electrically separated contacts of the semiconductor component, and **in that** the carrier board carries a contact of the semiconductor component.

5. Motor vehicle circuit arrangement according to one of the preceding claims,
**characterized in that**
the semiconductor component forms a switch or a diode between the carrier board and at least one of the printed circuit boards and/or **in that** at least one semiconductor component is formed as a transistor and/or **in that** the semiconductor component mechanically connects the carrier board to at least one of the printed circuit boards.

6. Motor vehicle circuit arrangement according to one of the preceding claims,
**characterized in that**
the carrier board forms a common electrical potential with a respective one terminal of the semiconductor component connecting the carrier board to the printed circuit board and/or **in that** exactly one electrical potential is present on the carrier board during operation.

7. Motor vehicle circuit arrangement according to one of the preceding claims,
**characterized in that**
the metallic substrate of the printed circuit board forms respectively an electrical potential with a terminal of the semiconductor component which connects the printed circuit board to the carrier board, and **in that** an electrical potential for driving the semiconductor component is guided on the printed circuit boards, respectively.

8. Motor vehicle circuit arrangement according to one of the preceding claims,
**characterized in that**
the carrier board is arranged sandwich-like between the printed circuit boards and/or **in that** the carrier board and the printed circuit boards are arranged at least substantially parallel to one another along at least one surface, in particular in that flat sides of the carrier board and the printed circuit boards are arranged substantially parallel to one another.

9. Motor vehicle circuit arrangement according to one of the preceding claims,
**characterized in that**
the carrier board and/or the printed circuit boards are dimensionally stable and/or rigid and/or are formed from a solid material and/or are formed monolithically.

10. Motor vehicle circuit arrangement according to one of the preceding claims,
**characterized in that**
the carrier board and/or the printed circuit boards are coated with an insulating layer.

11. Motor vehicle circuit arrangement according to one of the preceding claims,
**characterized in that**
the carrier board and the printed circuit boards are encapsulated in a common housing and are guided out of the housing by a respective metallic contact tab (6a, 6b) and/or that the carrier board and the printed circuit boards have a metallic contact tab at one respective end face and/or that the contact tab of the carrier board is arranged at one end facing away from the metallic contact tabs of the printed circuit boards.

12. Motor vehicle circuit arrangement according to one of the preceding claims,
**characterized in that**
the carrier board and the printed circuit boards are formed from aluminium or copper or alloys thereof and/or **in that** the carrier board and the printed circuit board are formed from a common metallic substrate and/or **in that** the carrier board and the printed circuit boards are formed from a flat material, in particular a strip or sheet metal and/or **in that** the carrier board and the printed circuit boards are tinned at least in parts, in particular in the region of contact flaps and/or **in that** the contact flaps are formed integrally with the carrier board and the respective printed circuit board.

13. Motor vehicle circuit arrangement according to one of the preceding claims,
**characterized in that**
the carrier board and the printed circuit boards are arranged on a common metallic substrate (40), an electrical separating layer being arranged between the substrate and the carrier board and the printed circuit boards.

14. Motor vehicle circuit arrangement according to one of the preceding claims,
**characterized in that**
the interface is a heat conductive layer.

15. Use of a motor vehicle circuit arrangement according to one of the preceding claims, in particular for an electronic safety battery terminal, a starting current switch-on limitation, an on-board voltage stabilizer, a Q-diode, and/or a battery overcharge protection.

## Revendications

1. Agencement de circuits d'un véhicule automobile, comprenant :
- au moins deux composants à semi-conducteurs (30) et
- au moins une première plaque de support métallique (2a) et une première plaquette métallique de circuits imprimés (2b) ainsi qu'une deuxième plaquette métallique de circuits imprimés (2b),
- où la plaque de support est placée à distance de la première et de la deuxième plaquette de circuits imprimés, isolées électriquement, et
- la plaque de support est placée électriquement en liaison avec au moins la première plaquette de circuits imprimés, via au moins un premier composant à semi-conducteurs (30) et
- la plaque de support est placée électriquement en liaison avec au moins la deuxième plaquette de circuits imprimés, via au moins un deuxième composant à semi-conducteurs (30), de sorte que la plaque de support et les plaquettes de circuits imprimés forment un tripôle électrique,
- où la plaque de support est court-circuitée électriquement par une borne d'alimentation respective du premier et du deuxième composant à semi-conducteurs, où la borne d'alimentation respective est mise en contact électriquement par un revêtement métallique (12) appliqué directement sur la plaque de support, et
- la première et la deuxième plaquette de circuits imprimés présentent des pistes conductrices (18), et une borne d'alimentation respectivement du premier composant à semi-conducteurs est court-circuitée, via un plot de contact (20) placé à distance des pistes conductrices, par la première plaquette de circuits imprimés, une borne d'alimentation respectivement du deuxième composant à semi-conducteurs étant court-circuitée par la deuxième plaquette de circuits imprimés, via ce même plot de contact placé à distance des pistes conductrices, où le plot de contact est disposé dans une zone de contact qui, configurée comme un passage (21) en forme de fenêtre, est disposée dans une couche isolante (16) de la plaquette de circuits imprimés, et une borne de commutation respectivement du premier et du deuxième composant à semi-conducteurs est court-circuitée par la piste conductrice respective.

2. Agencement de circuits d'un véhicule automobile selon la revendication 1,
**caractérisé**
**en ce que** le tripôle électrique est monté au moins comme l'un des circuits :
A) cosse de batterie de sécurité électronique,
B) limitation de mise en circuit du courant de démarrage,
C) stabilisateur de tension du réseau de bord,
D) diode Q,
E) protection contre une surcharge de la batterie.

3. Agencement de circuits d'un véhicule automobile selon la revendication 1 ou 2,
**caractérisé**
**en ce que** la plaque de support supporte, au cours du fonctionnement, un premier potentiel du tripôle, et en ce que les plaquettes de circuits imprimés présentent deux potentiels du tripôle, qui sont différents et qui diffèrent du premier potentiel.

4. Agencement de circuits d'un véhicule automobile selon l'une quelconque des revendications précédentes,
**caractérisé**
**en ce que** les plaquettes de circuits imprimés sont isolées électriquement l'une de l'autre et/ou en ce qu'au moins l'une des plaquettes de circuits imprimés comprend deux contacts du composant à semi-conducteurs, lesdits contacts étant séparés électriquement l'un de l'autre, et en ce que la plaque de support comprend un contact du composant à semi-conducteurs.

5. Agencement de circuits d'un véhicule automobile selon l'une quelconque des revendications précédentes,
**caractérisé**
**en ce que** le composant à semi-conducteurs forme un commutateur ou une diode placé(e) entre la plaque de support et au moins l'une des plaquettes de circuits imprimés et/ou en ce qu'au moins un composant à semi-conducteurs est formé comme un transistor et/ou en ce que le composant à semi-conducteurs relie mécaniquement la plaque de support, à au moins l'une des plaquettes de circuits imprimés.

6. Agencement de circuits d'un véhicule automobile selon l'une quelconque des revendications précédentes,
**caractérisé**
**en ce que** la plaque de support forme un potentiel électrique commun avec respectivement une connexion du composant à semi-conducteurs reliant la plaque de support à la plaquette de circuits imprimés et/ou en ce que précisément un potentiel électrique s'applique sur la plaque de support, au cours du fonctionnement.

7. Agencement de circuits d'un véhicule automobile selon l'une quelconque des revendications précédentes,
**caractérisé**
**en ce que** le substrat métallique des plaquettes de circuits imprimés forme à chaque fois un potentiel électrique avec une connexion du composant à semi-conducteurs reliant la plaquette de circuits
imprimés, à la plaque de support, et en ce qu'un potentiel électrique, servant à la commande du composant à semi-conducteurs, est guidé à chaque fois sur les plaquettes de circuits imprimés.

8. Agencement de circuits d'un véhicule automobile selon l'une quelconque des revendications précédentes,
**caractérisé**
**en ce que** la plaque de support est disposée en sandwich entre les plaquettes de circuits imprimés et/ou en ce que la plaque de support et les plaquettes de circuits imprimés sont disposées au moins le long d'une surface et en étant au moins pratiquement parallèles entre elles, en particulier en ce que des côtés plats de la plaque de support et des plaquettes de circuits imprimés sont disposés en étant pratiquement parallèles entre eux.

9. Agencement de circuits d'un véhicule automobile selon l'une quelconque des revendications précédentes,
**caractérisé**
**en ce que** la plaque de support et/ou les plaquettes de circuits imprimés sont configurées en étant indéformables et/ou en résistant à la flexion et/ou en se composant d'un matériau plein et/ou en étant formées de façon monolithique.

10. Agencement de circuits d'un véhicule automobile selon l'une quelconque des revendications précédentes,
**caractérisé**
**en ce que** la plaque de support et/ou les plaquettes de circuits imprimés sont recouvertes d'une couche isolante.

11. Agencement de circuits d'un véhicule automobile selon l'une quelconque des revendications précédentes,
**caractérisé**
**en ce que** la plaque de support et les plaquettes de circuits imprimés sont encapsulées dans un boîtier commun et sont guidées par une languette de contact métallique (6a, 6b) qui leur permet d'être extraites du boîtier et/ou en ce que la plaque de support et les plaquettes de circuits imprimés présentent une languette de contact métallique placée à chaque fois au niveau d'une extrémité côté frontal et/ou en ce que la languette de contact de la plaque de support est disposée au niveau d'une extrémité placée à l'opposé des languettes de contact métalliques des plaquettes de circuits imprimés.

12. Agencement de circuits d'un véhicule automobile selon l'une quelconque des revendications précédentes,
**caractérisé**
**en ce que** la plaque de support et les plaquettes de circuits imprimés sont formées en se composant d'aluminium ou de cuivre ou d'alliages de ces métaux et/ou en ce que la plaque de support et les plaquettes de circuits imprimés sont formées à partir d'un substrat métallique commun et/ou en ce que la plaque de support et les plaquettes de circuits imprimés sont formées à partir d'un matériau plat, en particulier tel qu'une bande ou une tôle et/ou en ce que la plaque de support et les plaquettes de circuits imprimés sont étamées au moins dans certaines parties, en particulier dans la zone des languettes de contact et/ou en ce que les languettes de contact sont conçues en formant une seule et même pièce avec la plaque de support et avec la plaquette respective de circuits imprimés.

13. Agencement de circuits d'un véhicule automobile selon l'une quelconque des revendications précédentes,
**caractérisé**
**en ce que** la plaque de support et les plaquettes de circuits imprimés sont disposées sur un substrat métallique commun (40), où une couche séparatrice électrique est disposée entre le substrat et la plaque de support et les plaquettes de circuits imprimés.

14. Agencement de circuits d'un véhicule automobile selon l'une quelconque des revendications précédentes,
**caractérisé**
**en ce que** la couche séparatrice est une couche conductrice de la chaleur.

15. Utilisation d'un agencement de circuits d'un véhicule automobile selon l'une quelconque des revendications précédentes, en particulier pour une cosse de batterie de sécurité électronique, pour une limitation de mise en circuit du courant de démarrage, pour un stabilisateur de tension de réseau de bord, pour une diode Q et/ou pour une protection contre une surcharge de la batterie.
